# EUROPÄISCHE PATENTSCHRIFT

(11) **EP 0 979 992 B1**
(45) Veröffentlichungstag und Bekanntmachung des Hinweises auf die Patenterteilung: **08.10.2003**
(21) Anmeldenummer: 99112978.4
(22) Anmeldetag: 05.07.1999
(51) Int. Cl.: G01L 9/00

(54) **Verfahren zur Herstellung eines Mikromechanischen Sensors**
Method of Manufacturing a Micromechanical Sensor
Procédé de fabrication d'un capteur micromécanique

(30) Priorität: 11.08.1998 DE 19836341
(43) Veröffentlichungstag der Anmeldung: 16.02.2000
(73) Patentinhaber: Infineon Technologies AG, 81669 München (DE)
(72) Erfinder: Aigner, Robert, Dr., 81675 München (DE); Bever, Thomas, Dr., 81739 München (DE); Timme, Hans-Jörg, Dr., 85521 Ottobrunn (DE)
(74) Vertreter: Kottmann, Heinz Dieter, Dipl.-Ing.

(56) Entgegenhaltungen:
- DE-A- 3 445 774
- DE-A- 4 318 466
- DE-C- 19 648 424
- US-A- 5 677 560

## Beschreibung

Die Erfindung betrifft ein Verfahren zur Herstellung eines mikromechanischen Sensors.

Für bestimmte Anwendungen, wie Drucksensoren oder Mikrofone, sind stark miniaturisierte Sensoren erwünscht mit deren Hilfe beispielsweise Druckunterschiede bzw. Druckschwankungen oder Schallschwingungen gemessen werden können.

Ein mikromechanischer Sensor für Anwendungen in der Akustik ist in der US 5,146,435 beschrieben. Der beschriebene Sensor besteht aus einer beweglichen Membran und einer Stützstruktur aus einem Siliziumwafer. Oberhalb des Siliziumwafers ist eine Gegenelektrode angeordnet, die über die Waferfläche hinausragt und einen Hohlraum zwischen Membran und Gegenelektrode bildet. Die Gegenelektrode weist auf der Oberseite Ventilationsöffnungen auf, die zum Zwecke des Luftaustausches des Hohlraums mit der Umgebung verbunden sind. Unterhalb der beweglichen Membran ist der Siliziumwafer entfernt, so dass das akustische Signal an die Membran herantreten kann. Das Prinzip, nach dem der mikromechanische Sensor arbeitet, basiert auf einer Volumenänderung des Hohlraums, welche eine Kapazitätsänderung des durch die Membran und die Gegenelektrode gebildeten Kondensators bewirkt. Zur Messung der Kapazität befinden sich auf der Oberseite des Wafers elektrische Kontakte. Eine Auswerteelektronik auf dem Wafer ist nicht vorgesehen.

In der DE-A-196 48 424 ist ein mikromechanischer Sensor beschrieben, welcher für Druckmessungen und Schallmessungen verwendet werden kann. Der Sensor ist auf einem SOI-Substrat (Silicon Oxide Isolator) aufgebaut und umfasst eine Membran aus polykristallinem Silizium, welche über einer Abstandsschicht auf der Substratunterlage angeordnet ist. Die Abstandsschicht und die polykristalline Membran bilden einen Hohlraum, wobei sich auf der gegenüberliegenden Seite der Membran eine Gegenelektrode im Bereich des Substrats befindet. Somit ist die Gegenelektrode unterhalb der Membran angeordnet. Die Membran befindet sich in Richtung der Oberseite des Chips. Zum Luftausgleich sind Ventilationsöffnungen vorhanden, die in Richtung der Unterseite des Substrats ausgerichtet sind. Die polykristalline Membran bildet gemeinsam mit den übrigen Ebenen eine Chipfläche, die nicht eben ist.

Ein Nachteil des vorstehend beschriebenen Aufbaus für einen mikromechanischen Sensor ist es, dass der Sensor nicht auf einfache Weise hergestellt werden kann. Aufgrund der gegenüber der Substratfläche beabstandet angeordneten Membranfläche ist die Topologie des halbfertigen Sensors während der Fertigung nicht geeignet, um darauf auf einfache Weise eine Halbleiterschaltung aufzubringen. Eine Fertigung der Schaltung mit einer geringen Anzahl von Prozessschritten ist daher nicht möglich. Ein weiterer Nachteil der vorstehenden Anordnung ist es, dass die Membran aus polykristallinem Silizium besteht. Polykristallines Silizium weist nicht befriedigende Eigenschaften hinsichtlich der mechanischen Festigkeit auf, was beispielsweise bei der Fertigung Probleme mit sich bringt. So muss das halbfertige Sensorelement wesentlich vorsichtiger gehandhabt werden, um Beschädigungen der empfindlichen Sensorfläche zu vermeiden. Weiterhin ergeben sich Nachteile bei der Fertigung von bekannten mikromechanischen Sensoren mit einer in Richtung der Oberseite ausgerichteten Membran. So kann es beispielsweise bei der Montage oder beim Sägen des Wafers zu Einbußen in'der Produktqualität kommen.

Weiterhin beschreibt die DE-A-34 45 774 einen mikromechanischen Sensor auf einem Halbleitersubstrat, umfassend einen Hohlraum, eine Membran, eine Gegenelektrode und Ventilationsöffnungen, welche das Volumen des Hohlraumes mit der Umgebung verbinden. Die Ventilationsöffnungen sind in Richtung der Oberseite des Wafers ausgerichtet, und die Gegenelektrode ist Bestandteil einer Beschichtungsebene, die über die gesamte Chipfläche reicht, so dass auf diese Beschichtungsebene eine elektronische Halbleiterschaltung in an sich bekannter Halbleitertechnologie aufgebracht werden kann.

Schließlich offenbart die DE-A-43 18 466 ein Verfahren zur Herstellung eines mikromechanischen Sensors umfassend die Schritte: Herstellen einer Opferschicht auf einem Halbleitersubstrat in einem Bereich der Substratoberfläche, epitaktisches Aufwachsenlassen eines halbleitenden Materials in der Weise, dass eine ebene Schicht entsteht, die den Bereich der Opferschicht überragt, wobei diese Schicht im Bereich der Opferschicht polykristallin aufwächst, gegebenenfalls Glätten dieser ebenen Schicht, Ätzen von Öffnungen und Entfernen des Materials der Opferschicht.

Aufgabe der vorliegenden Erfindung ist die Bereitstellung eines einfach durchführbaren Verfahrens zur Herstellung eines mikromechanischen Sensors, der die vorstehend beschriebenen Nachteile von bekannten Sensoren nicht aufweist.

Zur Lösung dieser Aufgabe sieht die vorliegende Erfindung ein Verfahren mit den Merkmalen des Patentanspruchs 1 vor.

Vorteilhafte Ausführungsformen ergeben sich aus den abhängigen Ansprüchen 2 bis 6.

Nachfolgend wird die Erfindung anhand der Zeichnungen näher erläutert. Es zeigen:
- Figur 1: einen mikromechanischen Sensor, welcher auf einem SOI-Substrat hergestellt worden ist, und
- Figur 2: einen mikromechanischen Sensor, welcher auf einem herkömmlichen Siliziumsubstrat hergestellt worden ist.

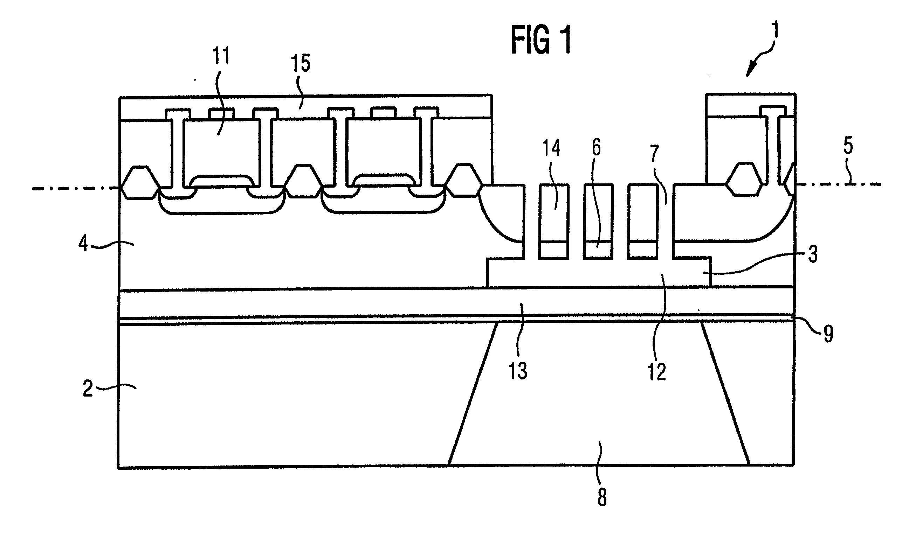

Die Herstellung des mikromechanischen Sensors gemäß Figur 1 erfolgt in der Weise, dass zunächst auf ein SOI-Substrat 2 eine Opferschicht 3, welche vorzugsweise auf Siliziumoxid besteht, aufgebracht wird, und im Anschluss daran eine epitaktische Schicht 4 aufwachsen gelassen wird. Die Dicke der Schicht 4 ist relativ viel größer als die Dicke der Schicht 3, so dass sich nach diesem Schritt eine ebene Fläche 5 ergibt. Gegebenenfalls ist es notwendig, dass diese Fläche 5 zur Verbesserung der Glätte poliert wird. Im Allgemeinen wächst die epitaktische Schicht 4 im Bereich des Wafers 2 einkristallin auf, im Bereich des Materials der Opferschicht 3 entsteht polykristallines Silizium. Zur Verbesserung der Qualität der epitaktischen Schicht 4 kann vorzugsweise auf die Opferschicht 3 eine Seed-Schicht aufgebracht werden, welche beispielsweise aus polykristallinem Silizium bestehen kann. Im Anschluss daran werden auf übliche Weise Gräben in die epitaktische Schicht 4 eingeätzt, so dass Kanäle 7 entstehen, die bis zur Opferschicht 3 ragen. Diese Kanäle werden dann vorzugsweise mit Siliziumoxid gefüllt. Im Anschluss daran wird als weiterbildendes Konstruktionsmerkmal auf herkömmliche Weise eine elektronische Halbleiterschaltung in Dünnschichttechnologie aufgebracht. Hierbei kann es sich beispielsweise um einen an sich bekannten CMOS, Bi-CMOS oder bipolaren Prozess handeln. Danach wird die Rückseite des Substrats stromlos beispielsweise mit KOH oder TMAH geätzt, so dass eine Öffnung 8 entsteht. In einem weiteren Ätzschritt, welcher sich nach oder vor der Rückseitenätzung durchführen lässt, werden die Oxide in den Kanälen und in der Opferschicht 3 entfernt. Hierdurch entsteht ein Hohlraum 12, welcher über die Kanäle 7 mit der Umgebung verbunden ist. Die Kanäle 7 durchdringen daher vorzugsweise die Gegenelektrode 14. Die Membran 13, welche bei der Rückseitenätzung entsteht, ist so dünn ausgeführt, dass sie beispielsweise unter Einfluss einer Schallwelle zu Schwingungen angeregt werden kann. Die Dicke der Membran 13 liegt vorzugsweise zwischen 0,2 µm und 1 µm. Es ist möglich die Membran 13 im Seitenbereich der Abstützung dünner auszuführen, so dass die Schwingung der Membran bereits bei kleineren Schallamplituden erfolgen kann. Vorzugsweise hat die Membran eine Gesamtlänge im Bereich von 100 µm bis 2000 µm. Die Rückseitenätzung wird zweckmäßigerweise stromlos, insbesondere mit einer KOH-Ätzlösung, durchgeführt.

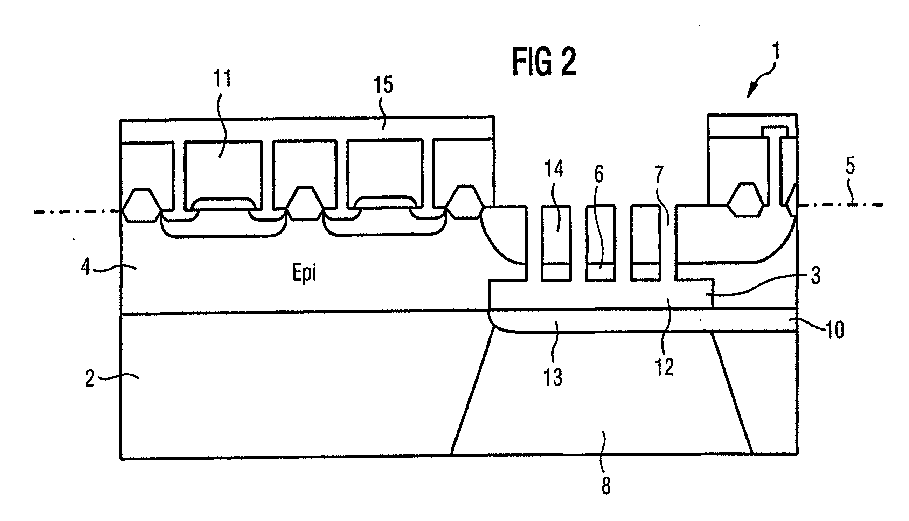

Zur Herstellung des mikromechanischen Sensors in Figur 2 wird ein gegenüber dem vorstehenden Verfahren abgewandelter Herstellungsweg beschritten. Gemäß dem Verfahren zur Herstellung des mikromechanischen Sensors nach Figur 1 wir bei der rückseitigen Ätzung der Ätzprozess durch eine Siliziumoxidschicht 9 abgestoppt. Bei Verwendung eines SOI-Wafers wird diese Schicht durch das eingesetzte Wafermaterial automatisch geliefert. Die Herstellung des Sensors in Figur 2 erfolgt ohne die Verwendung eines SOI-Substrats Zunächst wird das Substrat vor dem Aufwachsen der Schichten 3 und 4 mit einer geeigneten Dotierung, welche beispielsweise bei einem p-Wafer eine n-Dotierung sein kann, versehen. Ein so dotierter Bereich 10 ist vorzugsweise räumlich begrenzt. Der dotierte Bereich 10 dient als Ätzstopp bei der rückseitigen Ätzung des Hohlraums 8. Vorzugsweise kommen für die rückseitige Ätzung zwei Verfahren zur Anwendung:
a) Der Bereich 10 wird mit einem geeigneten Material, beispielsweise Bor, hochdotiert, insbesondere mit einer Dotierungskonzentration von mehr als 10¹⁹ cm⁻³. Als Wafer wird ein n- oder p-Wafer eingesetzt. Die Ätzung des Hohlraums erfolgt entweder mit EDP (toxic), KOH, insbesondere in heiß konzentrierter Form oder mit TMAH.
b) Herstellung des Bereichs 10 mit einer schwach p-oder n-leitenden Dotierung mit einer Dotierungskonzentration von insbesondere weniger als 10¹⁵ cm⁻³. Als Wafer wird ein stark p- oder n-dotierter Wafer eingesetzt, mit einer Dotierungskonzentration von insbesondere größer als 10¹⁸ cm⁻³. Die Ätzung des Hohlraums erfolgt elektrochemisch mit HF oder KOH.

Die Entfernung der Opferschicht 3 erfolgt vorzugsweise durch Nassätzung.

Der mit dem erfindungsgemäßen Verfahren hergestellte Sensor ist beispielsweise bei Drucksensoren, insbesondere Relativdrucksensoren, und Mikrophonen verwendbar. Bei Sensoren für den Einsatz in Mikrophonen ergeben sich Vorteile, wenn die Membran in Richtung der Unterseite der Chipfläche angeordnet ist.

Ein wesentlicher Vorteil liegt auch darin, dass die Membran aus einkristallinem Material bestehen kann. Hierdurch ergibt sich eine verbesserte mechanische Beständigkeit im Vergleich zu Membranen aus polykristallinem Material. Gegenüber aus dem Stand der Technik bekannten Verfahren zur Herstellung von mikromechanischen Sensoren ist das erfindungsgemäße Herstellungsverfahren auf vereinfachte Weise durchführbar. So kann beispielsweise auf die Herstellung von Zwischenschichten, wie sie in der DE-A-196 48 424 beschrieben sind, verzichtet werden.

Das Verfahren der vorliegenden Erfindung bietet darüber hinaus den Vorteil einer ebenen Chipfläche. Beispielsweise bei der Herstellung von Schaltkreisen auf dem Chip des Sensors nach oder während der Herstellung der Sensorstruktur werden die Verfahrensschritte durch eine ebene Chipfläche vereinfacht.

## Patentansprüche

1. Verfahren zur Herstellung eines mikromechanischen Sensors umfassend die Schritte:
a) Herstellen einer Opferschicht (3) auf einem Halbleiter-Substrat (2) in einem Bereich der Oberfläche des Substrats (2),
b) epitaktisches Aufwachsenlassen eines halbleitenden Materials in der Weise, daß eine ebene Schicht (5) entsteht, die den Bereich der Opferschicht (3) überragt, wobei diese ebene Schicht (5) im Bereich der Opferschicht (3) polykristallin aufwächst,
c) Glätten der ebenen Schicht (5),
d) Ätzen von Öffnungen (7) und Füllen der Öffnungen mit einem geeigneten Material,
e) Aufbringen einer elektronischen Halbleiter-Schaltung (11) auf der ebenen Schicht (5) und
f) Entfernen des Füllmaterials in den Öffnungen (7) und der Opferschicht (3) und Rückseitenätzen des Halbleiter-Substrats (2) zur Freilegung einer Membran (13) und zur Erzeugung einer Sensor-öfnung (8).

2. Verfahren nach Anspruch 1,
**dadurch gekennzeichnet, daß**
das Halbleiter-Substrat (2) ein Wafer mit einer OxidZwischenschicht (9) ist, die als Ätzstopp beim Rückseitenätzen wirkt.

3. Verfahren nach Anspruch 1,
**dadurch gekennzeichnet, daß**
das Stoppen der Rückseitenätzung durch geeignete Dotierung des Halbleiter-Substrats (2) erreicht wird.

4. Verfahren nach einem der Ansprüche 1 bis 3,
**dadurch gekennzeichnet,daß**
nach Schritt a) eine Seed-Schicht auf die Opferschicht (3) aufgebracht wird, die beim Wachstum der ebenen Schicht (5), die in Schritt b) hergestellt wird, für verbesserte Wachstumsbedingungen sorgt.

5. Verfahren nach einem der Ansprüche 1 bis 4,
**dadurch gekennzeichnet,daß**
das Rückseitenätzen in Abhängigkeit von der verwendeten Schicht für den Ätzstopp entweder durch stromloses oder durch elektrochemisches Naßätzen erfolgt.

6. Verfahren nach einem der Ansprüche 1 bis 5,
**dadurch gekennzeichnet, daß**
die Opferschicht und das Füllmaterial, welches sich in den Öffnungen (7) befindet, Siliziumoxid verwendet wird.

## Claims

1. Method for producing a micromechanical sensor comprising the following steps:
a) production of a sacrificial layer (3) on a semiconductor substrate (2) in a region of the surface of the substrate (2),
b) epitaxial growth of a semiconducting material in such a way that a planar layer (5) projecting above the region of the sacrificial layer (3) is produced, the said planar layer (5) growing in polycrystalline form in the region of the sacrificial layer (2),
c) smoothing of the planar layer (5),
d) etching of openings (7) and filling of the openings with a suitable material,
e) application of an electronic semiconductor circuit (11) on the planar layer (5), and
f) removal of the filling material in the openings (7) and the sacrificial layer (3) and rear-side etching of the semiconductor substrate (2) in order to uncover a diaphragm (13) and in order to produce a sensor opening (8).

2. Method according to Claim 1,
**characterized in that**
the semiconductor substrate (2) is a wafer with an oxide intermediate layer (9), which acts as an etching stop during the rear-side etching.

3. Method according to Claim 1,
**characterized in that**
the stopping of the rear-side etching is achieved by means of suitable doping of the semiconductor substrate (2).

4. Method according to one of Claims 1 to 3,
**characterized in that**,
after step a), a seed layer is applied to the sacrificial layer (2), which provides for improved growth conditions during the growth of the planar layer (5) produced in step b).

5. Method according to one of Claims 1 to 4,
**characterized in that**
the rear-side etching is effected either by electroless or by electrochemical wet-etching, depending on the layer used for the etching stop.

6. Method according to one of Claims 1 to 5,
**characterized in that**
silicon oxide is used [lacuna] the sacrificial layer and the filling material situated in the opening (7).

## Revendications

1. Procédé de fabrication d'un capteur micromécanique, qui consiste :
a) à produire une couche (3) sacrificielle d'un substrat (2) semiconducteur dans une partie de la surface du substrat (2),
b) à faire croître par épitaxie un matériau semiconducteur, de façon à former une couche (5) plane qui dépasse de la partie de la couche (3) sacrificielle, cette couche (5) plane ayant une croissance polycristalline dans la partie de la couche (3) sacrificielle,
c) à rendre lisse la couche (5) plane,
d) à ménager par attaque des ouvertures (7) et à emplir les ouvertures d'un matériau approprié,
e) à déposer un circuit (11) électronique à semiconducteur sur la couche (5) plane et
f) à enlever la matière de charge dans les ouvertures (7) et la couche (3) sacrificielle et à attaquer dans la face arrière le substrat (2) semiconducteur pour dégager une membrane (13) et pour produire une ouverture (8) de capteur.

2. Procédé suivant la revendication 1, **caractérisé en ce que** le substrat (2) semiconducteur est une tranche ayant une couche (9) intermédiaire d'oxyde, qui sert d'arrêt d'attaque lors de l'attaque par la face arrière.

3. Procédé suivant la revendication 1, **caractérisé en ce qu'**on obtient l'arrêt de l'attaque par la face arrière par un dopage approprié du substrat (2) semiconducteur.

4. Procédé suivant l'une des revendications 1 à 3, **caractérisé en ce qu'**après le stade a), on dépose une couche germe sur la couche (3) sacrificielle qui sert, lors de la croissance de la couche (5) plane qui est produite au stade b), à améliorer les conditions de la croissance.

5. Procédé suivant l'une des revendications 1 à 4, **caractérisé en ce qu'**on effectue l'attaque par la face arrière en fonction de la couche utilisée pour l'arrêt d'attaque, soit sans courant, soit par une attaque électrochimique en voie humide.

6. Procédé suivant l'une des revendications 1 à 5, **caractérisé en ce que** la couche sacrificielle et le matériau de remplissage qui se trouve dans les ouvertures (7) est de l'oxyde de silicium.
